**Europäisches Patentamt**

**European Patent Office**

**Office européen des brevets**

(19)

(11) Veröffentlichungsnummer: **0 115 625**

**B1**

(12)

# EUROPÄISCHE PATENTSCHRIFT

(45) Veröffentlichungstag der Patentschrift:
**06.04.87**

(51) Int. Cl.⁴: **G 01 R 31/36**, G 01 R 19/165

(21) Anmeldenummer: **83113047.1**

(22) Anmeldetag: **23.12.83**

(54) **Verfahren und Anordnung zur optischen und/oder akustischen Anzeige des Ladezustandes einer Batterie oder eines Akkumulators.**

(30) Priorität: **07.01.83 DE 3300284**

(43) Veröffentlichungstag der Anmeldung:
**15.08.84 Patentblatt 84/33**

(45) Bekanntmachung des Hinweises auf die Patenterteilung:
**08.04.87 Patentblatt 87/15**

(84) Benannte Vertragsstaaten:
**AT BE CH DE FR GB IT LI LU NL SE**

(56) Entgegenhaltungen:
**DE-A-2 408 041**
**DE-A-2 517 138**

(73) Patentinhaber: **Braun Aktiengesellschaft,
Rüsselsheimer Strasse 22, D-6000 Frankfurt/Main
(DE)**

(72) Erfinder: **Lang, Gerhard, Merzhäuser Strasse 26,
D-6395 Altweilnau (DE)**

(74) Vertreter: **Einsele, Rolf, Braun Aktiengesellschaft
Postfach 1120 Frankfurter Strasse 145, D-6242
Kronberg Taunus (DE)**

LIBER, STOCKHOLM 1987

## Beschreibung

Die Erfindung bezieht sich auf ein Verfahren zur optischen und/oder akustischen Anzeige des Ladezustandes bzw. der Ladereserve einer Batterie oder eines Akkumulators zur Spannungsversorgung eines elektrischen Verbrauchers über einen ein-, aus- und wahlweise umschaltbaren Betriebsartenschalter sowie auf eine Schaltungsanordnung zur Durchführung des Verfahrens.

Aus der DE-A-25 17 138 ist eine Schaltungsanordnung zur Überwachung der Versorungsspannung batteriebetriebener Geräte bekannt, bei der der Ladezustand der Batterie mit Hilfe eines Referenzelementes überwacht wird, wobei das Unterschreiten der Batteriespannung unterhalb der durch das Referenzelement vorgegebenen Schaltschwelle eine Anzeigeeinrichtung auslöst, die dem Benutzer des batteriebetriebenen Gerätes anzeigt, daß der Ladezustand der Batterie ein baldiges Auswechseln bzw. Aufladen erforderlich macht. Das Referenzelement besteht bei der bekannten Schaltungsanordnung aus einem Schmitt-Trigger, dessen Schaltschwelle unabhängig von Änderungen der Batteriespannung ist. Der Schmitt-Trigger wird von einem parallel zur zu überwachenden Batterie geschalteten, veränderlichen RC-Glied angesteuert, wobei bei Unterschreiten der Schaltschwelle des Schmitt-Triggers die Anzeigeeinrichtung in Form einer lichtemittierenden Diode betätigt wird. Durch Veränderung des Widerstandswertes des RC-Gliedes mittels eines als Widerstandselement dienenden Potentiometers kann die Schaltschwelle so eingestellt werden, daß dem Benutzer des batteriebetriebenen Gerätes rechtzeitig ein Absinken des Ladezustandes der Batterie unterhalb eines kritischen Wertes angezeigt werden kann. Ist bei der bekannten Schaltunganordnung die Batterie ausreichend aufgeladen, so wird beim Einschalten des Gerätes die Schwellenspannung nur kurzzeitig unterschritten, so daß die lichtemittierende Diode kurzzeitig aufleuchtet und anschließend erlischt. Ist der Ladezustand der Batterie jedoch nicht mehr ausreichend, d.h. überschreitet die Batteriespannung nach dem Einschalten nicht mehr die am RC-Glied eingestellte Schwellenspannung, so wird mittels des Schmitt-Triggers die lichtemittierende Diode ständig zum Leuchten gebracht, so daß bei Unterschreiten der eingestellten Schwellenspannung eine ständige Energieentnahme aus der Batterie zur Speisung der lichtemittierenden Diode erfolgt.

Aufgabe der vorliegenden Erfindung ist es, ein Verfahren und eine Schaltungsanordnung zur automatischen Anzeige des Ladezustandes bzw. der Ladereserve einer Batterie bzw. eines Akkumulators anzugeben, die das Unterschreiten eines vorgebbaren Ladezustandswertes zuverlässig anzeigt und im Betrieb nur eine geringe Strombelastung und keine Leistungsentnahme aus der Batterie bzw. dem Akkumulator nach der Betätigung des Gerätes bzw. nach Unterschreiten des vorgegebenen Ladezustandswertes verursacht.

Diese Aufgabe wird erfindungsgemäß dadurch gelöst, daß der Betriebsartenschalter mehrere Einschaltstellungen für unterschiedliche Betriebsarten des elektrischen Verbrauchers aufweist, in denen ein Schwellwertschalter mit verschiedenen Schwellwerten während der jeweiligen Betriebsart des elektrischen Verbrauchers angesteuert wird und daß ein Triggerschalter vom Schwellwertschalter angesteuert wird, wenn der Ladezustand der Batterie in Abhängigkeit von der jeweiligen Belastung den vorbestimmten Lade-Grenzzustand unterschreitet.

Das erfindungsgemäße Verfahren ermöglicht ein rechtzeitiges Erkennen eines vorgegebenen Entladezustandes der Batterie eines elektrischen Gerätes und eine optische und/oder akustische Anzeige dieses Zustandes nach dem Ausschalten des Gerätes. Die Anzeige erfolgt automatisch ohne Bedienung einer besonderen Prüftaste oder Einschalten einer gesonderten Schaltstellung des Betriebsartenschalters. Während des Betriebes des elektrischen Gerätes wird die Batterie nur mit einem geringen Strom durch den Spannungsteiler und nicht mit einem zusätzlichen Stromfluß durch die optische und/oder akustische Anzeigeeinrichtung bei Unterschreiten des eingestellten Schwellwertes belastet. Im ausgeschalteten Zustand nimmt die Überwachungsschaltung keinen Strom auf.

Eine Schaltungsanordnung zur Durchführung des erfindungsgemäßen Verfahrens ist dadurch gekennzeichnet, daß in Reihe zu den Einschaltkontakten des Betriebsartenschalters ein einstellbarer Spannungsteiler geschaltet ist, an dem die Basis eines ersten Transistors angeschlossen ist, dessen Kollektor einerseits über einen widerstand direkt bzw. über einen Widerstand und einen Spannungsteilerwiderstand mit den Einschaltkontakten des Betriebsartenschalters und andererseits mit der Basis eines weiten Transistors verbunden ist, dessen Kollektor-Emitter-Strecke in Reihe zur optischen und/oder akustischen Anzeigeeinrichtung an den Ausschaltkontakt des Betriebsartenschalters geschaltet ist und parallel zu dessen Kollektor-Basis-Strecke die Reihenschaltung eines Kondensators und eines Ladewiderstandes geschaltet ist.

Diese Schaltungsanordnung stellt sicher, daß eine optische und/oder akustische Anzeige des Entladezustandes der Batterie nach dem Ausschalten des Gerätes in Abhängigkeit von dem Zustand der Batterie während des Betriebes erfolgt und daß nach dem Ausschalten des Gerätes kein Strom auch bei Unterschreiten des Ladezustandes und damit Auslösung der optischen und/oder akustischen Anzeige verbraucht wird. Im Betrieb selbst ist nur ein geringer Stromverbrauch durch den Spannungsteiler gegeben, der jedoch aufgrund des hohen Widerstandswertes des Spannungsteilers als vernachlässigbar im Vergleich zum Stromverbrauch des eigentlichen elektrischen Verbrauchers bezeichnet werden kann.

Eine vorteilhafte Ausgestaltung der erfindungsgemäßen Lösung ist dadurch gekennzeichnet, daß der Betriebsartenschalter drei Schaltstellungen aufweist, in deren erster der elektrische Verbraucher ausgeschaltet ist und eine Verbindung zwischen der Batterie bzw. Akkumulator und der Anzeigeeinrichtung besteht, in deren zweiter der elektrische Verbraucher in einer ersten Betriebsart eingeschaltet ist und eine Verbindung mit dem einen Anschluß des Spannungsteilers herstellt, dessen anderer Anschluß mit dem anderen Pol der Batterie bzw. des Akkumulators verbunden ist und in deren dritter Stellung der elektrische Verbraucher in einer zweiten Betriebsart eingeschaltet ist und eine Verbindung mit dem anderen Anschluß des Spannungsteilers herstellt.

Diese Ausgestaltung der erfindungsgemäßen Lösung ermöglicht es, den zum Ein-, Aus- und wahlweisen Umschalten des elektrischen Gerätes erforderlichen Betriebsartenschalter ohne zusätzliche Prüfstellung oder durch Vorsehen einer weiteren Prüftaste zur Anzeige des Entladezustandes der Barterie zu verwenden.

Eine weitere vorteilhafte Schaltungsanordnung zur Ausführung des erfindungsgemäßen Verfahrens ist dadurch gekennzeichnet, daß in der Einschaltstellung des Betriebsartenschalters ein erster Steuereingang eines Schwellwertschalters mit der Spannung der Batterie beaufschlagt ist und bei Unterschreiten eines eingestellten Schwellwertes ein Speicherglied lädt, das den Steuereingang eines Triggerschalters ansteuert, über dessen Schaltstrecke in der Ausschaltstellung des Schalters ein kontinuierlicher oder intermittierender Strom in die akustische und/oder optische Anzeigeeinrichtung fließt und daß in einer Zwischenstellung des Schalters ein zweiter Steuereingang des Schwellwertschalters erneut mit der Batteriespannung beaufschlagt ist und das Speicherglied entlädt, wenn der eingestellte Schwellwert des Schwellwertschalters wieder überschritten ist.

Diese Lösung ermöglicht eine optische und/oder akustische Anzeige bei Unterschreiten eines bestimmten, vorgebbaren Ladezustandswertes der Batterie bzw. des Akkumulators nach Beendigung des Betriebs des von der Batterie bzw. dem Akkumulator gespeisten elektrischen Verbrauchers ohne zusätzliche Prüftaste oder Schaltstellung des Geräteschalters, so daß der Benutzer in jedem Falle auf einen niedrigen Ladezustand aufmerksam gemacht wird. Die erfindungsgemäße Lösung eignet sich daher insbesondere für eine Anwendung in elektrischen Kleingeräten, die jeweils für eine bestimmte Zeitdauer betätigt werden, so daß der vorgebbare Ladezustandswert so bemessen werden kann, daß eine bestimmte Zeitdauer oder Häufigkeit der Inbetriebnahme des elektrischen Gerätes mit der noch vorhandenen Ladung des Akkumulators bzw. der Batterie möglich ist. Ein besonderer Vorteil der erfindungsgemäßen Schaltungsanordnung besteht darin, daß die optische und/oder akustische Alarmauslösung unter besonderer Berücksichtigung kurzzeitig hoher Belastungen der Batterie bzw. des Akkumulators, beispielsweise aufgrund unterschiedlicher Belastungsarten erfolgt, so daß ein durch hohe Belastung bedingtes Absinken der Batterie- bzw. Akkumulatorspannung nicht zur Anzeige führt, wenn der Ladezustand der Batterie bzw. des Akkumulators noch einen entsprechend häufigen Betrieb ermöglicht. Während des Betriebs des elektrischen Gerätes wird die Batterie nur mit einem geringen zusätzlichen Strom belastet und nach dem Ausschalten des Gerätes wird für eine begrenzte Zeitdauer nur der geringe Strom für die Anzeigeeinrichtung entnommen.

Eine weitere vorteilhafte Ausgestaltung ist dadurch gegekennzeichnet, daß der Schalter mehrere Kontaktbahnen aufweist, die so angeordnet sind, daß in der Einschaltstellung die mit der Batterie verbundene zweite Kontaktbahn sowohl mit der mit dem elektrischen Verbraucher verbundenen ersten Kontaktbahn als auch mit der mit dem ersten Steuereingang des Schwellwertschalters verbundenen sechsten Kontaktbahn, in der Zwischenstellung des Schalters die zweite Kontaktbahn sowohl mit dder ersten Kontaktbahn als auch mit der mit dem zweiten Steuereingang des Schwellwertschalters verbundenen siebenten Kontaktbahn und in der Ausschaltstellung des Schalters die zweite Kontaktbahn mit der an den Schaltstreckeneingang des Triggerschalters angeschlössenen fünften Kontaktbahn verbunden ist.

Diese Ausgestaltung gestattet es, mit einfachen Mitteln, ein kurzzeitiges, lastbedingtes Absinken der Batteriespannung bei der Alarmauslösung zu berücksichtigen und den Alarm erst nach Beendigung des Betriebes des elektrischen Verbrauchers auszulösen.

Eine weitere vorteilhafte Ausgestaltung ist dadurch gekennzeichnet, daß der Schwellwertschalter einen Spannungsteiler, der einerseits mit der sechsten Kontaktbahn und andererseits mit Masse- oder Bezugspotential verbunden ist und an dessen ersten Spannungsteilerabgriff die Basis eines dritten Transistors angeschlossen ist, eine anodenseitig mit der siebenten Kontaktbahn und kathodenseitig über einen vierten Widerstand mit dem Kollektor des dritten Transistors verbundene fünfte Diode sowie einen die sechste Kontaktbahn und die vierte Kontaktbahn überbrückenden fünften Widerstand aufweist, wobei der Emitter des dritten Transistors mit Masse- oder Bezugspotential verbunden ist.

Diese Ausgestaltung ermöglicht es, in einfacher Weise einen Schwellwertschalter aufzubauen, bei dem sowohl der jeweilige Schwellwert in einfacher Weise eingestellt und ein lastbedingtes kurzfristiges Absinken der Batteriespannung bei der Auslösung der optischen und/oder akustischen Anzeigeeinrichtung berücksichtigt werden kann.

Eine weitere vorteilhafte Ausgestaltung ist dadurch gekennzeichnet, daß der Triggerschalter einen vierten und fünften Transistor in Komplementär-Darlington-Schaltung enthält, wobei die Basis des vierten Transistors über einen sechsten Widerstand sowohl mit dem Kollektor des dritten Transistors als auch über einen dritten Kondensator mit dem Kollektor des fünften Transistors, der Kollektor des vierten Transistors mit der Basis des fünften Transistors, der Emitter des fünften Transistors mit dem fünften Schaltkontakt des Schalters und der Kollektor des fünften Transistors mit dem einen Anschluß der optischen und/oder akustischen Anzeigeeinrichtung verbunden ist, deren anderer Anschluß an Masse- oder Bezugspotential angeschlossen ist.

Der Aufbau des Triggerschalters ermöglicht es, eine intermittierende optische und/oder akustische Anzeigeeinrichtung mit bestimmter, einstellbarer Freguenz sowie Dauer der Anzeige anzusteuern.

Eine weitere vorteilhafte Ausgestaltung ist dadurch gekennzeichnet, daß der Kollektor des vierten Transistors über einen vierten Kondensator mit dem fünften Schaltkontakt des Schalters verbunden ist.

Diese Ausgestaltung der erfindungsgemäßen Lösung sorgt für eine Unterdrückung des Ausschaltimpulses, wenn die Schaltschwelle noch nicht erreicht ist und der Schalter in die Ausschaltstellung gebracht worden ist.

Eine weitere vorteilhafte Ausgestaltung der erfindungsgemäßen Lösung ist dadurch gekennzeichnet, daß der Emitter des fünften Transistors an die Kathode einer sechsten Diode angeschlossen ist, deren Anode über einen dreizehnten Widerstand mit einem zweiten Abgriff des Spannungsteilers verbunden ist.

Diese Ausgestaltung der erfindungsgemäßen Lösung verhindert eine Stromaufnahme der Schaltungsanordnung in der Ausschaltstellung des Schalters über den Spannungsteiler des Schwellwertschalters sowie ein kurzzeitiges Wiedereinschalten des ersten Transistors durch Herabsetzen der Spannungsschwelle für den ersten Transistor, so daß ein Hystereseverhalten der Schaltung gewährleistet ist.

Eine weitere vorteilhafte Ausgestaltung der erfindungsgemäßen Lösung ist dadurch gekennzeichnet, daß parallel zur Basis-Emitter-Strecke des fünften Transistors ein elfter Widerstand geschaltet ist.

Diese Ausgestaltung der erfindungsgemäßen Lösung gewährleistet, daß der dritte Transistor nach der Entladung des Speichergliedes sicher gesperrt bleibt, so daß die Schaltungsanordnung in der Ausschaltstellung des Schalters keinen Strom aufnimmt.

Eine weitere vorteilhafte Ausgestaltung der erfindungsgemäßen Lösung ist dadurch gekennzeichnet, daß der Spannungsteiler einen ersten, mit der sechsten Kontaktbahn des Schalters verbundenen Spannungsteilerwiderstand aufweist, dessen Verbindung mit einem fünften Spannungsteilerwiderstand den zweiten Spannungsteilerabgriff bildet, daß der fünfte Spannungsteilerwiderstand sowohl mit einem sechsten Spannungsteilerwiderstand als auch mit einem parallel zum sechsten Spannungsteilerwiderstand geschalteten NTC-Widerstand verbunden ist, wobei die Verbindung des fünften Spannungsteilerwiderstandes mit dem sechsten Spannungsteilerwiderstand bzw. dem NTC-Widerstand den ersten Spannungsteilerabgriff bildet und daß ein siebenter Spannungsteilerwiderstand sowohl an die Parallelschaltung des sechsten Spannungsteilerwiderstandes mit dem NTC-Widerstand einerseits und an Masse- oder Bezugspotential andererseits angeschlossen ist.

Das Einschalten eines NTC-Widerstandes in den Spannungsteiler gestattet es, neben einer zuverlässigen Einstellung der Schaltschweile Temperatureinflüsse auf die Schaltungsanordnung zu kompensieren, so daß eine fehlerhafte Anzeige bzw. Nichtanzeige weitgehend ausgeschlossen wird.

Zur Wechselspannungsstabilisierung der Schwellenspannung an der Basis des ersten Transistors dient ein parallel zur Basis-Kollektor-Strecke des dritten Transistors geschalteter fünfter Kondensator.

Schließlich gewährleistet in einer weiteren Ausgestaltung der erfindungsgemäßen Lösung ein an den Emitter des vierten Transistors angeschlossener achter Widerstand, der mit Masse- oder Bezugspotential verbunden ist, eine gleichbleibende Leuchtintensität der als optische Anzeigeeinrichtung dienenden lichtemittierenden Diode.

Anhand eines in der Zeichnung dargestellten Ausführungsbeispieles soll der der Erfindung zugrundeliegende Gedanke näher erläutert werden. Es zeigen:

Fig. 1 ein Schaltbild einer ersten Variante der Batteriereserveanzeige,

Fig. 2 ein Blockschaltbild einer zweiten Variante der Batteriereserveanzeige und

Fig. 3 ein detailliertes Schaltbild der Batteriereserveanzeige gemäß Fig. 1.

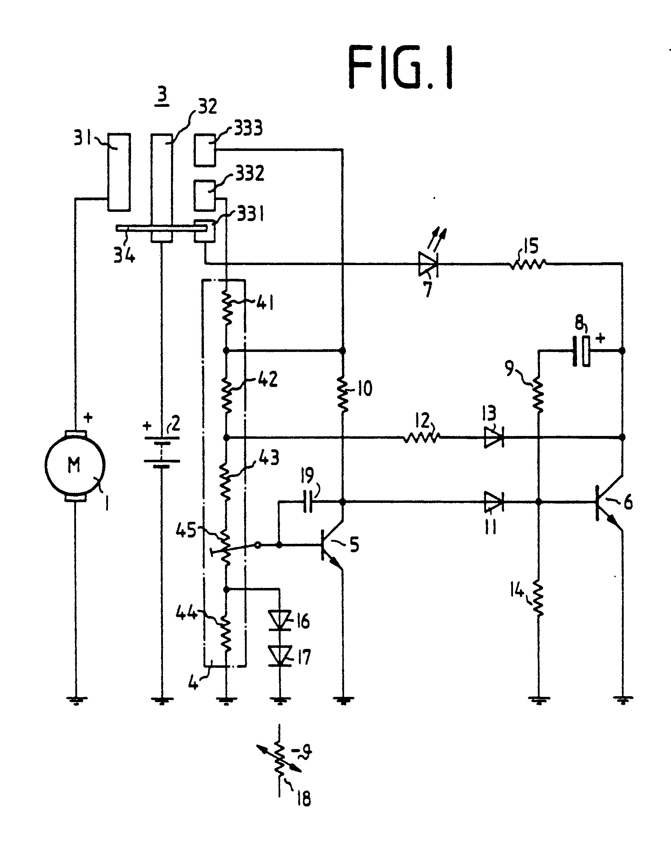

Das in Figur 1 dargestellte Schaltbild zeigt als elektrischen Verbraucher einen Gleichstrommotor 1, der über einen als Schiebeschalter ausgebildeten Betriebsartenschalter 3 aus einer Primär-Batterie 2 versorgt wird. Der Betriebsartenschalter 3 weist drei Schaltbahnen 31, 32, 33 auf, wobei die erste Schaltbahn 31 mit dem einen Anschluß des Gleichstrommotors 1, die zweite Schaltbahn 32 mit dem positiven Anschluß der Primär-Batterie 2 und die dritte Schaltbahn 33 mit der erfindungsgemäßen Schaltungsanordnung zur optischen und/oder akustischen Anzeige des Entladezustandes der Primär-Batterie 2 verbunden ist. Dabei ist die dritte Schaltbahn 33 in drei Abschnitte unterteilt, nämlich in einen Ausschaltkontakt 331, in einen Einschaltkontakt 332 sowie einen Umschaltkontakt 333. Ein die drei Schaltbahnen 31, 32, 33 überstreichender Kontaktgeber 34 verbindet in der Ausschaltstellung die mittlere Schaltbahn 32 mit dem Ausschaltkontakt 331 und in den beiden Einschaltstellungen die erste Schaltbahn 31, die zweite Schaltbahn 32 sowie entweder den Einschaltkontakt 332 oder den Umschaltkontakt 333.

Der Einschaltkontakt 332 ist mit einem Spannungsteiler 4 verbunden, der aus vier in Reihe geschalteten Spannungsteilerwiderständen 41, 42, 43, 44 sowie einem Einstellpotentiometer 45 besteht. Der Abgriff des Einstellpotentiometers 45 ist mit der Basis eines ersten Transistors 5 verbunden, dessen Kollektor über einen Kollektorwiderstand 10 mit dem Einschaltkontakt 332 verbunden ist. Von der Verbindung des ersten Spannungsteilerwiderstandes 41 mit dem zweiten Spannungsteilerwiderstand 42 ausgehend ist eine direkte Verbindung mit dem Umschaltkontakt 333 vorgesehen. Der Emitter des ersten Transistors 5 ist unmittelbar mit Masse- bzw. Bezugspotential verbunden. Parallel zur Basis-Kollektor-Strecke des ersten Transistors 5 ist ein Glättungskondensator 19 geschaltet, der die Empfindlichkeit der Schaltschwelle gegenüber der Welligkeit der Batteriespannung bei Motorlast verringert.

Der Kollektor des ersten Transistors 5 ist mit der Anode einer ersten Diode 11 verbunden, deren Kathode an die Basis eines zweiten Transistors 6 angeschloßen ist. Von der Verbindung des zweiten Spannungsteilerwiderstandes 42 mit dem dritten Spannungsteilerwiderstandes 43 ausgehend ist die Reihenschaltung eines ersten Widerstandes 12 mit einer zweiten Diode 13 vorgesehen, deren Kathode mit dem Kollektor des zweiten Transistors 6 verbunden ist. Zwischen der Basis des zweiten Transistors 6 und Masse- bzw. Bezugspotential ist ein zweiter Widerstand 14 vorgesehen. Der Emitter des zweiten Transistors 6 ist ebenso wie der Emitter des ersten Transistor 5 unmittelbar mit Masse- bzw. Bezugspotential verbunden.

An den Ausschaltkontakt 331 des Betriebsartenschalters 3 ist die Anode einer Leuchtdiode 7 angeschlossen, deren Kathode über einen dritten Widerstand 15 mit dem Kollektor des zweiten Transistors 6 verbunden ist. Parallel zur Basis-Kollektor-Strecke des zweiten Transistors 6 ist die Reihenschaltung eines Kondensators 8 und eines Ladewiderstandes 9 geschaltet.

Parallel zum vierten Spannungsteilerwiderstand 44 ist die Reihenschaltung einer dritten und vierten Diode 16, 17 mit kathodenseitigem Anschluß der vierten Diode 17 an Masse- bzw. Bezugspotential geschaltet. Anstelle der Reihenschaltung dieser beiden Dioden kann ein NTC-Widerstand vorgesehen werden. Die Reihenschaltung dieser beiden Dioden bzw. das Vorsehen des NTC-Widerstandes anstelle der beiden Dioden dient zur Temperaturkorrektur der Schaltschwelle an der Basis des ersten Transistors 5.

Nachstehand soll die Funktionsweise der dargestellten erfindungsgemäßen Schaltungsanordnung näher erläutert werden.

In der Einschaltstellung des Betriebsartenschalters 3, d. h. in der Stellung, wo der Schaltkontakt 34 die erste Schaltbahn 31, die mittlere Schaltbahn 32 und den Einschaltkontakt 332 verbindet, ist der Spannungsteiler 4 parallel zur Primär-Batterie 2 geschaltet. Mit Hilfe des Einstellpotentiometers 45 des Spannungsteilers 4 wird eine zur Primär-Batteriespannung proportionale Schaltschwelle für den ersten Transistor 5 eingestellt. Unterschreitet die Primär-Batteriespannung die eingestellte Schaltschwelle, so wird der erste Transistor 5 gesperrt. Ein positiver Spannungssprung am Kollektor des ersten Transistors 5 steuert über den Kollektorwiderstand 10, die erste Diode 11 und den zweiten Widerstand 14 die Basis des zweiten Transistors 6 an und damit den zweiten Transistor 6 durch. Dadurch springt der Kollektor des zweiten Transitors 6 vermindert um den unvermeidlichen Emitter-Kollektor-Spannungsabfall auf Masse- bzw. Bezugspotential.

Mit dem Durchschalten des zweiten Transistors 6 wird der im Sperrzustand des zweiten Transistors 6 auf eine seiner Polarität entsprechende positive Spannung aufgeladene Kondensator 8 auf die Basisspannung des zweiten Transistors 6 umgeladen und zwar entgegengesetzt zur ursprünglichen Polarität im Sperrzustand des zweiten Transistors 6. Im durchgeschalteten Zustand des zweiten Transistors 6 wird die Reihenschaltung des ersten Widerstandes 12 mit der zweiten Diode 13 parallel zur Reihenschaltung des dritten Spannungsteilerwiderstandes 43, des Einstellpotentiometers 45 und des vierten Spannungsteilerwiderstandes 44 geschaltet. Durch diese Parallelschaltung wird die Basisspannung des ersten Transistors 5 weiter herabgesetzt und infolge der Stromkopplung der Sperrvorgang des ersten Transistors 5 unterstützt. Durch die herabgesetzte Basisspannung des ersten Transistors erreicht dieser erst wieder bei einer erhöhten Primär-Batteriespannung die Schaltschwelle, bei der der erste Transistor aufgesteuert wird. Diese Betriebsweise stellt ein Hystereseverhalten der Schaltschwelle sicher.

Wird anschließend der Betriebsartenschalter 3 ausgeschaltet, d.h. wird der Schaltkontakt 34 in die Ausschaltstellung gebracht, in der er lediglich die mitlere Schaltbahn 32 und den Ausschaltkontakt 31 kontaktiert, so erhält die Leuchtdiode 7 positive Primär-Batteriespannung.

Über die Leuchtdiode 7, den dritten Widerstand 15, den Ladewiderstand 9 und den zweiten Widerstand 14 wird der Kondensator 8 erneut umgeladen. Am dritten Widerstand 14 fällt eine positive Spannung ab, die die Basis und damit den zweiten Transistor 6 aufsteuert. Während des Umladevorganges, dessen Zeitkonstante durch das Produkt aus der Kapazität des Kondensators 8 und dem Widerstandswert des Ladewiderstandes 9 bestimmt wird, erhält die Leuchtdiode 7 Strom über den dritten Widerstand 15 und die Kollektor-Emitter-Strecke des zweiten Transistors 6 und leuchtet auf. Dies ist jedoch nur dann der Fall, wenn zuvor die Basis des zweiten Transistors 6 ein positives Potential erhält und der zweite Transistor 6 durchgeschaltet ist. Wird dagegen bei der vorangegangenen Schaltstellung des Betriebsartenschalters 3 die am Einstellpotentiometer 45 eingestellte Schaltschwelle nicht erreicht und damit kein positiver Spannungssprung an der Basis des zweiten Transistors 6 bewirkt, so bleibt beim nachfolgenden Umschalten des Betriebsartenschalters 3 in die Ausschaltstellung der zweite Transistor 6 gesperrt, und es findet somit keine Umladung des Kondensators 8 und kein Aufleuchten der Leuchtdiode 7 statt.

Wie aus der vorstehenden Beschreibung der Funktionsweise der erfindungsgemäßen Schaltungsanordnung deutlich hervorgeht, leuchtet die Leuchtdiode 7 während eines bestimmten, einstellbaren Zeitraumes nach dem Ausschalten des Gerätes auf, wobei die Zeitspanne durch die Zeitkonstante des Ladevorganges des Kondensators 8 und damit durch die Werte des Ladewiderstandes 9 und des Kondensators 8 bestimmt wird.

Steht der Schaltkontakt 34 des Betriebsartenschalters 3 in der Umschaltstellung, d.h. verbindet er die erste Schaltbahn 31, die zweite Schaltbahn 32 und den Umschaltkontakt 333, so wird der erste Spannungsteilerwiderstand 41 mit dem Widerstand 10 in Reihe geschaltet und die am Einstellpotentiometer 45 eingestellte Schaltschwelle an der Basis des ersten Transistors 5 erst bei einer niedrigeren Primär-Batteriespannung erreicht.

Wird in der erfindungsgemäßen Schaltungsanordnung eine Primär-Batterie eingelegt oder ein aufgeladener Akkumulator angeschlossen, so leuchtet die Leuchtdiode 7 ebenfalls auf. Nach deren Verlöschen ist die erfindungsgemäße Schaltungsanordnung betriebsbereit, so daß auf diese Weise die richtige Polarität und ausreichende Kontaktgabe der eingelegten Batterie kontrolliert werden kann.

Der am Einstellpotentiometer 45 einstellbare Schwellwert zum Ansprechen der akustischen und/oder optischen Anzeigeeinrichtung kann so eingestellt werden, daß nach Erreichen des vorgegebenen Entladezustandes der Batterie 2 der Verbraucher 1 noch für eine bestimmte Zeit mit seinen Nenndaten zu betreiben ist. Dadurch wird sichergestellt, daß nach akustischer und/oder optischer Anzeige des erreichten Entladezustandes noch ein Betrieb des elektrischen Gerätes möglich ist und der Benutzer rechtzeitig an die Aufladung des Akkumulators bzw. an die Erneuerung der Primär-Batterie erinnert wird.

Variationen der erfindungsgemäßen Schaltungsanordnung sind in der Weise möglich, daß eine Anzeige des Entladezustandes der Batterie sowohl während des Betriebes des elektrischen Verbrauchers als auch nach dem Ausschalten des elektrischen Verbrauchers möglich ist. Eine weitere Abwandlung kann darin bestehen, daß der ausreichende Ladezustand der Batterie optisch über eine Leuchtdiode nach dem Ausschalten des Gerätes angezeigt wird, d.h., daß eine Anzeige stets dann erfolgt, wenn der vorgegebene Entladezustand noch nicht erreicht ist.

Obwohl das Ausführungsbeispiel anhand einer Leuchtdiode zur Anzeige des Entladezustandes der Primär-Batterie beschrieben wurde, ist es für den Fachmann ohne weiteres durchführbar, anstelle der Leuchtdiode 7 einen akustischen Signalgeber, beispielsweise einen Schwingquarz, einzusetzen oder mit einer optischen Leuchtdioden-Anzeige zu kombinieren.

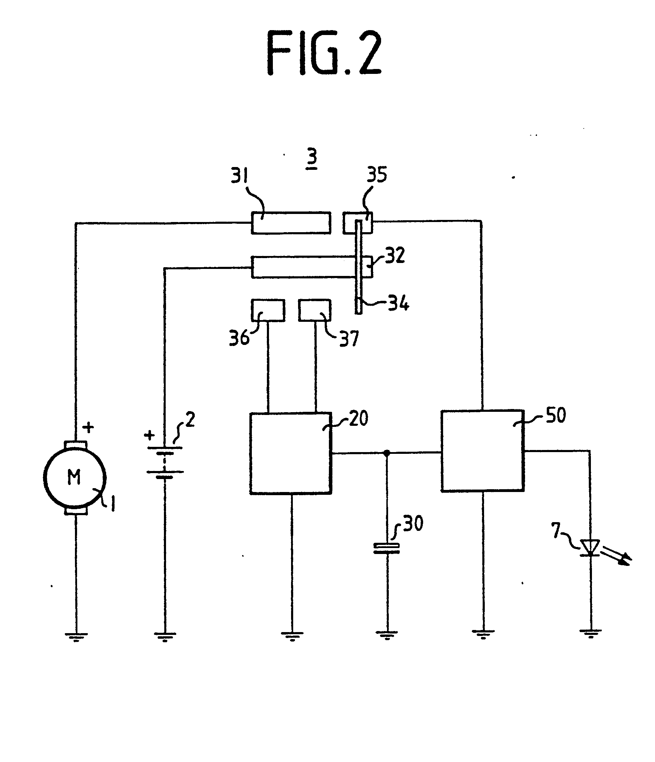

Das in Figur 2 dargestellte Blockschaltbild zeigt einen Gleichstrommotor 1 als elektrischen Verbraucher, der über einen Schalter 3 an eine Batterie 2 als Speisespannungsquelle gelegt werden kann. Der Schalter 3 weist einen Schaltkontakt 34 und fünf Kontaktbahnen 31 - 37 auf, von denen die erste Kontaktbahn 31 mit dem Gleichstrommotor 1 verbunden ist. Die zweite Kontaktbahn 32 ist an die Batterie 2 angeschlossen, während eine sechste Kontaktbahn 36 mit einem ersten Steuereingang eines Schwellwertschalters 20 verbunden ist. Eine siebente Kontaktbahn 37 ist an einen zweiten Steuereingang des Schwellwertschalters 20 gelegt, während eine fünfte Kontaktbahn 35 mit dem Lastanschluß eines Triggerschalters 50 verbunden ist, dessen Steuereingang sowohl mit einem Speicherglied 30 als auch mit dem Ausgang des Schwellwertschalters 20 verbunden ist. Der Ausgang des Triggerschalters 50 ist mit einer Leuchtdiode 7 als optischer Anzeigeeinrichtung verbunden.

In der Einschaltstellung überbrückt der Schaltkontakt 34 des Schalters 3 die erste, zweite und sechste Schaltbahn 31, 32, 36, während er in einer Zwischenstellung die erste, zweite und siebente Schaltbahn 31, 32, 37 und in der Ausschaltstellung die erste und fünfte Kontaktbahn 31, 35 überbrückt, so daß in der letztgenannten Schaltstellung der elektrische Verbraucher 1 von der Batterie 2 getrennt ist und lediglich eine Verbindung zum Triggerschalter 50 und damit bei Ansteuerung des Triggerschalters 50 zur optischen Anzeigeeinrichtung 7 besteht. Die Zwischenstellung des Betriebsartenschalters, bei der die erste, zweite und siebente Schaltbahn 31, 32, 37 überbrückt sind, kann beispielsweise eine Laststellung für eine zweite Betriebsart des elektrischen Verbrauchers 1 sein. So kann bei einem Einsatz der erfindungsgemäßen Lösung in einem netzunabhängig betreibbaren elektrischen Rasierapparat in der ersten Stellung des Betriebsartenschalters 3 ein Langhaarschneider betätigt werden, während in der Zwischenstellung das Gerät ein, der Langhaarschneider aber ausgeschaltet ist. In diesem Falle stellen die beiden Schalterstellungen verschiedene Belastungen für die Batterie 2 dar. Damit die Schaltschwelle für die Anzeigeeinrichtung beiden Belastungsarten angepaßt ist, gibt der Schwellwertschalter 20 unterschiedliche Schwellwerte ab, so daß beispielsweise bei der höheren Belastung in der ersten Schaltstellung die Schaltschwelle tiefer gelegt wird.

Die prinzipielle Funktionsweise der Blockschaltung gemäß Fig. 1 soll nachstehend kurz erläutert werden.

In der Einschaltstellung "1" des elektrischen Schalters 3 wird sowohl der elektrische Verbraucher 1 als auch der erste Steuereingang des Schwellwertschalters 20 mit der Batteriespannung $U_B$ beaufschlagt. Solange die Batteriespannung $U_B$ oberhalb eines im Schwellwertschalter 20 vorgebbaren Betrages unter Belastung mit dem elektrischen Verbraucher 1 liegt, bleibt der elektrische Schwellwertschalter 20 inaktiv. Unterschreitet die Batteriespannung $U_B$ unter Belastung den vorgegebenen Spannungswert, so wild der Schwellwertschalter 20 über seinen ersten Steuereingang gesetzt und bewirkt über die Verbindung des Schaltkontaktes 34 und der sechsten Kontaktbahn 36 ein Aufladen des Speichergliedes 30 und damit eine Aktivierung der Steuerschaltung zum Ansteuern des Triggerschalters 50. Wird der eingestellte Spannungswert nur kurzfristig infolge höherer Belastung, zum Beispiel beim Einschalten eines Langhaarschneiders unterschritten und damit das Speicherglied 30 infolge der Ansteuerung des Schwellwertschalters 20 über seinen ersten Steuereingang geladen, so wird das Speicherglied 30 über den dritten Transistor 21 sofort wieder gelöscht, wenn die Schwellwertspannung zuzüglich der eingestellten Hysteresespannung wieder überschritten wird

Ist der Schwellwertschalter 20 aufgrund der unter den eingestellten Minimalwert abgesunkenen Batteriespannung $U_B$ gesetzt und damit das Speicherglied 30 geladen, so wird der Triggerschalter 50 angesteuert und bewirkt, daß die Batteriespannung $U_B$ über die geschlossenen Schaltbahnen 31, 35 an die optische Anzeigeeinrichtung, d. h. die lichtemittierende Diode 7, gelegt wird. Anstelle oder zusätzlich zur optischen Anzeigeeinrichtung kann selbstverständlich auch eine akustische Anzeigeeinrichtung vorgesehen werden. Der Triggerschalter kann wahlweise eine intermittierende oder kontinuierliche Ansteuerung der optischen Anzeigeeinrichtung 7 vornehmen und wird solange angesteuert bis das Speicherglied 30 entladen ist. In der Einschaltstellung "2" des Betriebsartenschalters 3 wird der Schwellwert für den zweiten Belastungsfall tiefer gelegt, wobei die elektrischen Vorgänge ansonsten wir bei der Schaltstellung "1" ablaufen.

Wie aus der vorstehenden Prinzipdarstellung hervorgeht, wird durch die erfindungsgemäße Schaltungsanordnung sichergestellt, daß die optische Anzeige nach der Beendigung des Betriebs des elektrischen Verbrauchers 1 mit einer durch die Ladung des Speichergliedes 30 bestimmten Zeitdauer erfolgt, wobei die Steuerschaltung im Betrieb und während des Anzeigebetriebes des Gerätes nur eine geringe Leistung und nach Beendigung des Anzeigebetriebes keine Leistung aus der Batterie 2 entnimmt.

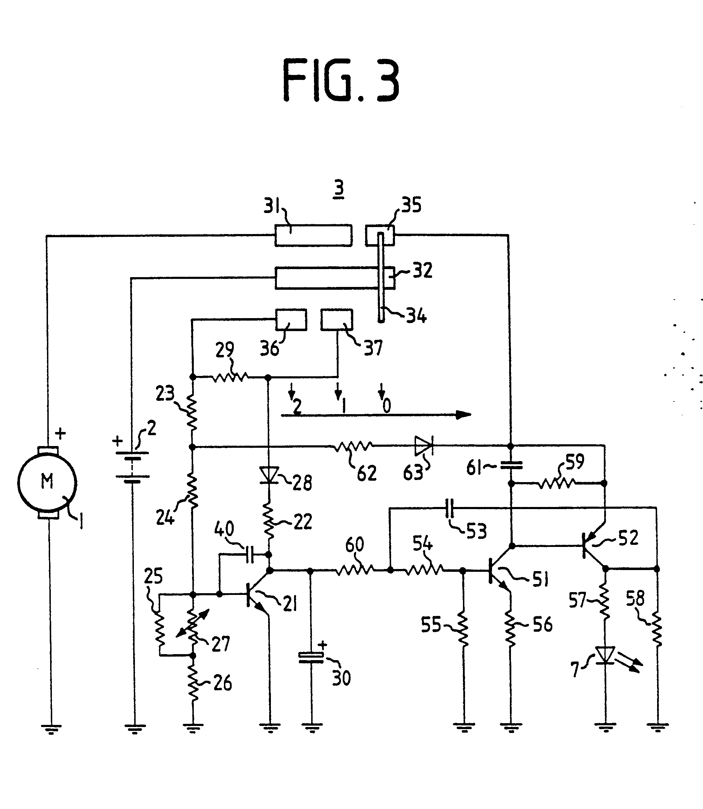

Das in Fig. 3 dargestellte detaillierte Schaltbild zeigt eine bevorzugte Ausführungsform der Batteriereserveanzeigeschaltung gemäß Fig. 2.

Die in Fig 3 dargestellte Schaltungsanordnung zur Batteriereserveanzeige zeigt analog zur Darstellung gemäß Fig. 2 einen über den Schaltkontakt 34 eines Schalters 3 an die erste Schaltbahn 31 und über die zweite Schaltbahn 32 an eine Batterie 2 anschließbaren Gleichstrommotor 1 als elektrischen Verbraucher. Der Schwellwertschalter 20 enthält einen Spannungsteiler mit vier in Reihe geschalteten Spannungsteilerwiderständen 23, 24, 25, 26, von denen der erste Spannungsteilerwiderstand 23 an die sechste Kontaktbahn 36 des Schalters 3 und der vierte Spannungsteilerwiderstand 26 an Masse- oder Bezugspotential angeschlossen ist. Parallel zum dritten Spannungsteilerwiderstand 25 ist ein NTC-Widerstand 27 geschaltet. Die Verbindung des zweiten Spannungsteilerwiderstandes 24 mit dem dritten Spannungsteilerwiderstand 25 bildet einen ersten Spannnungsteilerabgriff, an den die Basis eines ersten Transistors 21 angeschlossen ist.

Der Emitter des ersten Transistors 21 ist an Masse- oder Bezugspotential angeschlossen, während der Kollektor über einen vierten Widerstand 22 und eine fünfte Diode 28 an den siebenten Schaltkontakt 37 des Schalters 3 angeschlossen ist, wobei die fünfte Diode 28 anodenseitig mit dem siebenten Schaltkontakt 37 verbunden ist. Der sechste und siebente Schaltkontakt 36, 37 des Schalters 3 sind mittels eines fünften Widerstandes 29 überbrückt. Zusätzlich ist parallel zur Basis-Kollektor-Strecke des dritten Transistors 21 ein fünfter Kondensator 40 geschaltet, der bei einem rein ohmschen Verbraucher anstelle eines Gleichstrommotors 1 entfallen kann.

Das Speicherglied besteht aus einem zweiten Kondensator 30, der parallel zur Kollektor-Emitter-Strecke des dritten Transistors 21 geschaltet ist.

Der Triggerschalter ist über einen zwölften Widerstand 60 an den Kollektor des dritten Transistors 21 bzw. den einen Anschluß des zweiten Kondensators 30 angeschlossen und weist einen vierten Transistor 51 auf, dessen Basis sowohl über einen sechsten Widerstand 54 an den zwölften Widerstand 60 als auch über einen dritten Kondensator 53 an den Kollektor eines fünften Transistors 52 angeschlossen ist. Die Basis des vierten Transistors 51 ist über einen siebenten Widerstand 55 und der Emitter des vierten Transistors 51 über einen achten Widerstand 56 mit Masse- oder Bezugspotential verbunden.

Der Kollektor des vierten Transistors 51 ist einerseits mit der Basis des fünften Transistors 52 und andererseits über einen vierten Kondensator 61 mit der fünften Schaltbahn 35 des Schalters 3 verbunden. Der Kollektor des fünften Transistors 52 ist über einen neunten Widerstand 57 mit der Anode einer Leuchtdiode 7 als optische Anzeigeeinrichtung und über einen zehnten Widerstand 58 mit Masse- oder Bezugspotential verbunden. Parallel zur Basis-Emitter-Strecke des fünften Transistors 52 ist ein elfter Widerstand 59 geschaltet.

Der vierte und fünfte Transistor 51, 52 bilden eine Komplementär-Darlington-Schaltung, wobei der vierte Transistor 51 als NPN-Transistor und der fünfte Transistor 52 als PNP-Transistor ausgebildet ist.

Der Emitter des fünften Transistors 52 ist sowohl unmittelbar mit der fünften Schaltbahn 35 des Schalters 3 als auch mit der Kathode einer sechsten Diode 63 verbunden, deren Anode über einen dreizehnten Widerstand 62 an einen zweiten Spannungsteilerabgriff des Spannungsteilers 23, 24, 25, 26 geschaltet ist, der durch die Verbindung des vierten Spannungsteilerwiderstandes 23 mit dem fünften Spannungsteilerwiderstand 24 gebildet wird.

Die in der Darstellung gemäß Fig. 2 eingezeichneten Schalterstellungen zeigen mit "2" eine erste Laststellung des Schalters, mit der Schaltstellung "1" eine zweite Laststellung und mit der Schaltstellung "0" die Ausschaltstellung des Schalters 3.

Nachstehend soll die Funktionsweise der detaillierten Schaltungsanordnung gemäß Figur 2 näher erläutert werden.

Mit den Spannungsteilerwiderständen 23, 24, 25, 26 und dem NTC-Widerstand 27 wird je nach der Stellung oder "2" des als Schiebeschalter ausgebildeten Schalters 3 eine Spannungsschwelle an die Basis des dritten Transistors 21 gelegt. Wird durch die sinkende Batteriespannung $U_B$ die eingestellte Schwellspannung des dritten Transistors 21 unterschritten, so sperrt der dritte Transistor 21 und der zweite Kondensator 30 wird über die Reihenschaltung der fünften Diode 28 mit dem vierten Widerstand 22 aufgeladen. Ist der zweite Kondensator 30 voll aufgeladen, so wird der vierte Transistor 51 des Triggerschalters über den zwölften Widerstand 60, den sechsten Widerstand 54 und den siebenten Widerstand 55 durchgeschaltet.

Bei durchgeschaltetem vierten Transistor 51 schaltet, der komplementäre Darlington-Transistor bzw. der fünfte Transistor 52 ebenfalls durch. Über die Reihenschaltung des dreizehnten Widerstandes 62, der sechsten Diode 63 und des zehnten Widerstandes 58 wird die Spannungsschwelle des dritten Transistors 21 herabgesetzt, um ein kurzzeitiges Widereinschalten des dritten Transistors 21 zu verhindern, wodurch ein Hystereseverhalten des dritten Transistors 21 erzielt wird.

Wird anschließend der Schiebeschalter 3 in die Stellung "0" gebracht, so fließt vom Pluspol der Batterie 2 ein Strom über die Schaltstrecke des im leitfähigen Zustand befindlichen fünften Transistors 52, den neunten Widerstand 57 und die lichtemittierende Diode 7, die somit aufleuchtet. Ein vom Kollektor des fünften Transistors abzweigender Strom fließt über den dritten Kondensator 53, den sechsten Widerstand 54, die Basis-Emitter-Strecke des vierten Transistors 51 und den achten Widerstand 56 nach Masse- oder Bezugspotential und lädt den dritten Kondensator 53 um. Dadurch wird die Spannung am achten Widerstand 56 vergrößert und die Basis-Emitter-Spannung des vierten Tansistors 51 soweit heraufgesetzt, daß der vierte Transistor 51 sperrt. Infolgedessen sperrt auch der fünfte Transistor 52 und bringt die lichtemittierende Diode 7 zum Verlöschen.

Anschließend wird der dritte Kondensator 53 wiederum über den zweiten Kondensator 30, den zwölften Widerstand 60 und den zehnten Widerstand 58 auf die an ihm eingetragene Polarität umgeladen. Ist die Umladung des dritten Kondensators 53 beendet, so wird der vierte Transistor 51 infolge der am zweiten Kondensator 30 anliegenden Spannung, den zwölften Widerstand 60 und den sechsten Widerstand 54 und siebenten Widerstand 55 erneut angesteuert und schaltet durch.

Mit dem Durchschalten des vierten Transistors 51 schaltet auch der fünfte Transistor 52 durch und die lichtemittierende Diode 7 leuchtet erneut auf. Dieser Vorgang wiederholt sich solange bis der Kondensator 30 so weit entladen ist, daß keine erneute Ansteuerung des vierten Transistors 51 erfolgt. In dieser Zeit blinkt die lichtemittierende Diode mit einer im wesentlichen von der Kapazität des dritten Kondensators 53 abhängigen Freguenz, beispielsweise einer Frequenz von 3 Hz, auf.

Die Dauer des Blinkens der lichtemittierenden Diode 7 kann mittels der Kapazität des zweiten Kondensators 30 beliebig festgelegt werden, zum Beispiel auf eine Dauer von 15 Sekunden.

Der in die Verbindung des Kollektors des vierten Transistors 51 mit der fünften Kontaktbahn 35 des Schalters 3 geschaltete vierte Kondensator 61 sorgt für eine Unterdrückung des Ausschaltimpulses bei der Bewegung des Schaltkontaktes 34 des Schalters 3 in die Stellung "0" wenn die Schaltschwelle des Schwellwertschalters noch nicht erreicht ist.

Der parallel zur Basis-Emitter-Strecke des fünften Transistors 52 geschaltete elfte Widerstand 59 hält den fünften Transistor 52 nach der Entladung des zweiten Kondensators 30 sicher gesperrt, so daß die Steuerschaltung in der Stellung "0" des Schiebeschalters 3 keinen Strom aus der Batterie 2 aufnimmt. Der Emitterwiderstand bzw. der achte Widerstand 56 arbeitet mit dem vierten Transistor 51 in Spannungsgegenkopplung und sorgt für eine gleichbleibende Leuchtintensität der lichtemittierenden Diode 7.

Der parallel zur Basis-Kollektor-Strecke des dritten Transistors 21 geschaltete fünfte Kondensator 40 dient zur Wechselspannungsstabilisierung der Schwellwertspannung des dritten Transistors 21.

Wie bereits vorstehend erläutert wurde, ist die erfindungsgemäße Schaltungsanordnung dagegen gesichert, daß eine Fehlanzeige infolge kurzzeitig hoher Belastung beispielsweise durch den Anlaufstrom des Gleichstrommotors abgegeben wird. Die Anordnung der fünften Diode 28 verhindert ein Entladen des zweiten Kondensators 30 über den Spannungsteiler 23 - 27.

Schließlich verhindert die sechste Diode 63 eine Stromaufnahme der Steuerschaltung in der Schalterstellung "0" über den durch den fünften, sechsten und siebenten Spannungsteilerwiderstand 24, 25, 26 gebildeten Spannungsteilerzweig.

Wie der vorstehend beschriebenen Funktionsweise der Schaltungsanordnung zur Batteriereserveanzeige entnommen werden kann, wird in einfacher und wirkungsvoller Weise das Absinken der Batteriespannung $U_B$ während des Betriebes mit Betriebslast unterhalb eines voreinstellbaren Schwellwertes erfasst, gespeichert und nach Beendigung des Betriebs des elektrischen Verbrauchers 1 zur optischen und/oder akustischen Anzeige gebracht. Dabei wird sichergestellt, daß ein kurzzeitiges absinken der Batteriespannung infolge hoher Belastung berücksichtigt wird, wenn die Batteriespannung anschließend wieder über den eingestellten Schwellwert ansteigt. Die Steuerschaltung selbst arbeitet nach dem Ausschalten des elektrischen Verbrauchers 1 ohne zusätzliche Leistungsaufnahme aus der Batterie 2, so daß lediglich ein Strom für den Betrieb der optischen und/oder akustischen Anzeigeeinrichtung benötigt wird. Die Dauer und gegebenenfalls die Frequenz der Anzeige kann beliebig angesteuert und den jeweiligen Erfordernissen angepaßt werden. Aufgrund der mittels des dritten Kondensators 53 einstellbaren Freguemz kann sowohl eine konstante oder intermittierende Leuchtanzeige als auch bei gesteigerter Frequenz eine akustische Anzeige beispielsweise mittels eines Piezoelementes erfolgen.

**Patentansprüche**

1. Verfahren zur optischen und/oder akustischen Anzeige des Ladezustandes bzw. der Ladereserve einer Batterie oder eines Akkumulators zur Spannungsversorgung eines elektrischen Verbrauchers über einen Betriebsartenschalter, bei dem im eingeschalteten Zustand des elektrischen Verbrauchers der Ladezustand erfaßt und über die Dauer des Betriebs des elektrischen Verbrauchers gespeichert und nach Beendigung des Betriebs eine optische und/oder akustische Anzeigeeinrichtung bei Unterschreiten eines vorgegebenen Lade-Grenzzustandes angesteuert wird, dadurch gekennzeichnet, daß der Betriebsartenschalter (3) mehrere Einschaltstellungen für unterschiedliche Betriebsarten des elektrischen Verbrauchers (1) aufweist, in denen ein Schwellwertschalter (4; 20) mit verschiedenen Schwellwerten während der jeweiligen Betriebsart des elektrischen Verbrauchers (1) angesteuert wird und daß ein Triggerschalter (6; 50) vom Schwellwertschalter (4; 20) angesteuert wird, wenn der Ladezustand der Batterie (2) in Abhängigkeit von der jeweiligen Belastung den vorbebestimmten Lade-Grenzzustand unterschreitet.

2. Verfahren nach Anspruch 1, dadurch gekennzeichnet, daß in der Einschaltstellung des Betriebsartenschalters (3) die Steuerelektrode eines ersten elektronischen Schalters (5) an die Batterie (2) angeschlossen wird, wobei bei Unterschreiten einer festlegbaren Batteriespannung der erste elektronische Schalter (5) sperrt und einen zweiten elektronischen Schalter (6) ansteuert, der daraufhin durchgeschaltet wird, während der erste elektronische Schalter (5) gesperrt bleibt und daß bei durchgeschaltetem zweiten elektronischen Schalter (6) ein erster Kondensator (8) von einem ersten in einen zweiten, unterschiedliche Ladepolarität und -spannung aufweisenden Ladezustand umgeladen wird und bei einem Wechsel des Betriebsartenschalters (3) in die Ausschaltstellung der erste Kondensator (8) erneut in seinen ersten Ladezustand umgeladen wird, derart, daß während der Umladung der zweite elektronische Schalter (6) durchgeschaltet wird und über seine Schaltstrecke und die in Reihe zur Schaltstrecke geschaltete optische und/oder akustische Anzeigeeinrichtung (7) ein Strom fließt.

3. Schaltungsanordnung zur Durchführung des Verfahrens nach Anspruch 1 oder 2, dadurch gekennzeichnet, daß in Reihe zu den Einschaltkontakten (32, 33) des Betriebsartenschalters (3) ein einstellbarer Spannungsteiler (4) geschaltet ist, an dem die Basis eines ersten Transistors (5) angeschlossen ist, dessen Kollektor einerseits über einen Widerstand (10) direkt bzw. über einen Widerstand (10) und einen Spannungsteilerwiderstand (41) mit den

Einschaltkontakten (32, 33) des Betriebsartenschalter (3) und andererseits mit der Basis eines zweiten Transistors (6) verbunden ist, dessen Kollektor-Emitter-Strecke in Reihe zur optischen und/oder akustischen Anzeigeeinrichtung (7) an den Ausschaltkontakt (31) des Betriebsartenschalters (3) geschaltet ist und parallel zu dessen Basis-Emitter-Strecke die Reihenschaltung des Kondensators (8) und eines Ladewiderstandes (9) geschaltet ist.

4. Schaltungsanordnung nach Anspruch 3, dadurch gekennzeichnet, daß der Betriebsartenschalter (3) drei Schaltstellungen aufweist, in deren erster der elektrische Verbraucher (1) ausgeschaltet ist und eine Verbindung zwischen der Batterie (2) und der Anzeigeeinrichtung (7) besteht, in deren zweiter der elektrische Verbraucher (1) in einer ersten Betriebsart eingeschaltet ist und eine Verbindung mit dem einen Anschluß des Spannungsteilers (4) herstellt, dessen anderer Anschluß mit dem anderen Pol der Batterie (2) verbunden ist und in deren dritter Stellung der elektrische Verbraucher (1) in einer zweiten Betriebsart eingeschaltet ist und eine Verbindung mit dem anderen Anschluß des Spannungsteilers (4) herstellt.

5. Schaltungsanordnung nach Anspruch 3 oder 4, dadurch gekennzeichnet, daß die Basis des ersten Transistors (5) an einen Abgriff eines Potentiometers (45) des Spannungsteilers (4) angeschlossen ist, das in Reihe zu mehreren Widerständen (41, 42, 43, 44) geschaltet ist.

6. Schaltungsanordnung nach einem der Ansprüche 3 - 5, dadurch gekennzeichnet, daß an den einen Anschluß des Potentiometers (45) einerseits und an Masse- bzw. Bezugspotential bzw. den anderen Batterieanschluß andererseits die Reihenschaltung zweier Dioden (16, 17) mit anodenseitigem Anschluß am Potentiometer (45) angeschlossen ist.

7. Schaltungsanordnung nach einem der Ansprüche 3 - 5, dadurch gekennzeichnet, daß an den einen Anschluß des Potentiometers (45) einerseits und Masse- bzw. Bezugspotential bzw. den anderen Batterieanschluß andererseits ein NTC-Widerstand (18) angeschlossen ist.

8. Schaltungsanordnung nach einem der Ansprüche 3-7, dadurch gekennzeichnet, daß parallel zur Basis-Kollektor-Strecke des ersten Transistors (5) ein Glättungskondensator (7) geschaltet ist.

9. Schaltungsanordnung nach einem der Ansprüche 3-8, dadurch gekennzeichnet, daß der Kollektor des ersten Transistors (5) mit der Anode einer Diode (11) verbunden ist, deren Kathode an der Basis des zweiten Transistors (6) angeschlossen ist.

10. Schaltungsanordnung nach einem der Ansprüche 3-9, dadurch gekennzeichnet, daß an die Verbindung des zweiten und dritten Spannungsteilerwiderstandes (42, 43) einerseits und an den Kollektor des zweiten Transistors (6) andererseits die Reihenschaltung eines ersten Widerstandes (12) und einer zweiten Diode (13) angeschlossen ist, wobei die Diode (13) kathodenseitig mit dem Kollektor des Transistors (6) verbunden ist.

11. Schaltungsanordnung nach einem der Ansprüche 3-10, dadurch gekennzeichnet, daß parallel zur Basis-Emitter-Strecke das zweiten Transistors (6) ein zweiter Widerstand geschaltet ist.

12. Schaltungsanordnung zur Durchführung des Verfahrens nach Anspruch 1, dadurch gekennzeichnet, daß in der Einschaltstellung des Betriebsartenschalters (3) ein erster Steuereingang eines Schwellwertschalters (20) mit der Spannung der Batterie (2) beaufschlagt ist und bei Unterschreiten eines eingestellten Schwellwertes ein Speicherglied (30) lädt, das den Steuereingang eines Triggerschalters (50) ansteuert, über dessen Schaltstrecke in der Ausschaltstellung des Schalters (3) ein kontinuierlicher oder intermittierender Strom in die akustische und/oder optische Anzeigeeinrichtung (7) fließt und daß in einer Zwischenstellung des Schalters (3) ein zweiter Steuereingang des Schwellwertschalters (20) erneut mit der Batteriespannung beaufschlagt ist und das Speicherglied (30) entlädt, wenn der eingestellte Schwellwert des Schwellwertschalters (20) wieder überschritten ist.

13. Schaltungsanordnung nach Anspruch 12, dadurch gekennzeichnet, daß der Schalter (3) mehrere Kontaktbahnen (31-37) aufweist, die so angeordnet sind, daß in der Einschaltstellung die mit der Batterie (2) verbundene zweite Kontaktbahn (32) sowohl mit der mit dem elektrischen Verbraucher (1) verbundenen ersten Kontaktbahn (31) als auch mit der mit dem ersten Steuereingang des Schwellwertschalters (20) verbundenen sechsten Kontaktbahn (36), in der Zwischenstellung des Schalters (3) die zweite Kontaktbahn (32) sowohl mit der ersten Kontaktbahn (31) als auch mit der mit dem zweiten Steuereingang des Schwellwertschalters (20) verbundenen siebenten Kontaktbahn (37) und in der Ausschaltstellung des Schalters (3) die zweite Kontaktbahn (32) mit der an den Schaltstreckeneingang des Triggerschalters (50) angeschlossenen fünften Kontaktbahn (35) verbunden ist.

14. Schaltungsanordnung nach Anspruch 12 oder 13, dadurch gekennzeichnet, daß der Schwellwertschalter (20) einen Spannungsteiler (23 - 27), der einerseits mit der sechsten Kontaktbahn (36) und andererseits mit Masse- oder Bezugspotential verbunden ist und an dessen ersten Spannungsteilerabgriff die Basis eines dritten Transistors (21) angeschlossen ist, eine anodenseitig mit der siebenten Kontaktbahn (37) und kathodenseitig über einen vierten Widerstand (22) mit dem Kollektor des dritten Transistors (21) verbundene fünfte Diode sowie einen die sechste Kontaktbahn (36) und die vierte Kontaktbahn (37) überbrückenden fünften Widerstand (29) aufweist, wobei der Emitter des dritten Transistors (21) mit Masse- oder Bezugspotential verbunden ist.

15. Schaltungsanordnung nach Anspruch 12 oder 13, dadurch gekennzeichnet, daß das Speicherglied (30) aus einem zweiten Kondensator besteht, der einerseits an den Kollektor des dritten Transistors (21) und andererseits an Masse- oder Bezugspotential angeschlossen ist.

16. Schaltungsanordnung nach Anspruch 12 oder 13, dadurch gekennzeichnet, daß der Triggerschalter (50) einen vierten und fünften Transistor (51, 52) in Komplementär-Darlington-Schaltung enthält, wobei die Basis des vierten Transistors (51) über einen sechsten Widerstand (54) sowohl mit dem Kollektor des dritten Transistors (21) als auch über einen dritten Kondensator (53) mit dem Kollektor des fünften Transistors (52), der Kollektor des vierten Transistors (51) mit der Basis des fünften Transistors (52), der Emitter des fünften Transistors (52) mit dem fünften Schaltkontakt (35) des Schalters (3) und der Kollektor des fünften Transistors (52) mit dem einen Anschluß der optischen und/oder akustischen Anzeigeeinrichtung (7) verbunden ist, deren anderer Anschluß an Masse- oder Bezugspotential angeschlossen ist.

17. Schaltungsanordnung nach Anspruch 16, dadurch gekenzeichnet, daß der Kollektor des vierten Transistors (51) über einen vierten Kondensator (61) mit dem fünften Schaltkontakt (35) des Schalters (3) verbunden ist.

18. Schaltungsanordnung nach Anspruch 16 oder 17, dadurch gekennzeichnet, daß der Emitter des fünften Transistors (52) an die Kathode einer sechsten Diode (63) angeschlossen ist, deren Anode über einen dreizehnten Widerstand (62) mit einem zweiten Abgriff des Spannungsteilers (23-27) verbunden ist.

19. Schaltungsanordnung nach einem der Ansprüche 16 bis 18, dadurch gekennzeichnet, daß parallel zur Basis-Emitter-Strecke des fünften Transistors (52) ein elfter Widerstand (59) geschaltet ist.

20. Schaltungsanordnung nach Anspruch 14, dadurch gekennzeichnet, daß der Spannungsteiler (23 -27) einen ersten, mit der sechsten Kontaktbahn (36) des Schalters (3) verbundenen Spannungsteilwiderstand (23) aufweist, dessen Verbindung mit einem fünften Spannungsteilerwiderstand (24) den zweiten Spannungsteilerabgriff bildet, daß der fünfte Spannungsteilerwiderstand (24) sowohl mit einem sechsten Spannungsteilerwiderstand (25) als auch mit einem parallel zum sechsten Spannungsteilerwiderstand (25) geschalteten NTC-Widerstand (27) verbunden ist, wobei die Verbindung des fünften Spannungsteilerwiderstandes (24) mit dem sechsten Spannungsteilerwiderstand (25) bzw. dem NTC-Widerstand (27) den ersten Spannungsteilerabgriff bildet und da. ein siebenter Spannungsteilerwiderstand (26) sowohl an die Parallelschaltung des sechsten Spannungsteilerwiderstandes (25) mit dem NTC-Widerstand (27) einerseits und an Masse- oder Bezugspotential andererseits angeschlossen ist.

21. Schaltungsanordnung nach Anspruch 14 oder 20, dadurch gekennzeichnet, daß parallel zur Basis-Kollektor-Strecke des dritten Transistors (21) ein fünfter Kondensator (40) geschaltet ist.

22. Schaltungsanordnung nach einem der vorstehenden Ansprüche 3 bis 21, dadurch gekennzeichnet, daß die Anzeigeeinrichtung aus einer lichtemittierenden Diode (7) besteht, deren Anode mit dem Kollektor des fünften Transistors (52) und deren Kathode mit Masse- oder Bezugspotential verbunden ist.

23. Schaltungsanordnung nach einem der vorstehenden Ansprüche 3 bis 22, dadurch gekennzeichnet, daß der Emitter des vierten Transistors (51) über einen achten Widerstand (56) mit Masse- oder Bezugspotential verbunden ist.

**Claims**

1. A process for optically and/or acoustically indicating the state of charge or the reserve charge of a battery or of an accumulator for supplying voltage to an electrical load through a function selector switch wherein, when the electrical load is connected in, the state of charge is detected and stored during the period of operation of the electrical load and, after termination of the operation, an optical and/or acoustic indicating device is actuated if there is a drop below a preset limiting state of charge, characterised in that the function selector switch (3) comprises a plurality of "on" positions for different modes of operation of the electrical load (1) in which a threshold switch (4; 20) having various threshold values is actuated during the particular mode of operation of the electrical load (1) and that a trigger switch (6; 50) is actuated by the threshold switch (4; 20) if the charge of the battery (2) drops below the predetermined limiting state of charge, depending on the particular loading.

2. A process according to claim 1, characterised in that, in the "on" position of the function selector switch (3), the control electrode of a first electronic switch (5) is connected to the battery (2) and, on a drop below a battery voltage which can be fixed, the first electronic switch (5) is blocked and actuates a second electronic switch (6) which then becomes conducting while the first electronic switch (5) remains blocked, and that, when the second electronic switch (6) is conducting, a first capacitor (8) is changed over from a first into a second state of charge having a different polarity of charge and charging voltage, and when the function selector switch (3) changes over into the "off" position, the first capacitor (8) is again changed back into its first state of charge, in such a manner that during the reversal of charge, the second electronic switch

11

(6) becomes conducting and a current flows through its switching path and the optical and/or acoustic indicating device (7) connected in series with the switching path.

3. A circuit arrangement for carrying out the process according to claim 1 or 2, characterised in that, connected in series with the make contacts (32, 33) of the function selector switch (3) is an adjustable voltage divider (4) to which there is connected the base of a first transistor (5), the collector of which is connected on the one hand to the make contacts (32, 33) of the function selector switch (3) either directly through a resistor (10) or through a resistor (10) and a voltage-divider resistor (41) and on the other hand to the base of a second transistor (6), the collector-to-emitter path of which is connected in series with the optical and/or acoustic indicating device (7) at the break contact (31) of the function selector switch (3) and connected in parallel with the base-to-emitter path of which is the series connection of the capacitor (8) and a charging resistor (9).

4. A circuit arrangement according to claim 3, characterised in that the function selector switch (3) has three switch positions in the first of which the electrical load (1) is switched off and there is a connection between the battery (2) and the indicating device (7), in the second of which the electrical load (1) is switched on in a first mode of operation and establishes a connection to the one terminal of the voltage divider (4), the other terminal of which is connected to the other pole of the battery (2), and in the third position of which the electrical load (1) is switched on in a second mode of operation and establishes a connection to the other terminal of the voltage divider (4).

5. A circuit arrangement according to claim 3 or 4, characterised in that the base of the first transistor (5) is connected to a tap of a potentiometer (45) of the voltage divider (4), which potentiometer is connected in series with a plurality of resistors (41, 42, 43, 44).

6. A circuit arrangement according to one of the claims 3-5, characterised in that the series connection of two diodes (16, 17) is connected to the one terminal of the potentiometer (45) on the one hand and to earth or reference potential or to the other battery terminal on the other hand with connection to the potentiometer (45) at the anode side.

7. A circuit arrangement according to one of the claims 3-5, characterised in that an NTC resistor (18) is connected to the one terminal of the potentiometer (45) on the one hand and to earth or reference potential or to the other battery terminal on the other hand.

8. A circuit arrangement according to one of the claims 3-7, characterised in that a smoothing capacitor (7) is connected in parallel with the base-to-collector path of the first transistor (5).

9. A circuit arrangement according to one of the claims 3-8, characterised in that the collector of the first transistor (5) is connected to the anode of a diode (11), the cathode of which is connected to the base of the second transistor (6).

10. A circuit arrangement according to one of the claims 3-9, characterised in that the series connection of a first resistor (12) and of a second diode (13) is connected to the junction between the second and third voltage-divider resistors (42, 43) on the one hand and to the collector of the second transistor (6) on the other hand, the diode (13) being connected at the cathode side to the collector of the transistor (6).

11. A circuit arrangement according to one of the claims 3-10, characterised in that a second resistor is connected in parallel with the base-to-emitter path of the second transistor (6).

12. A circuit arrangement for carrying out the process according to claim 1, characterised in that, in the "on" position of the function selector switch (3) a first control input of a threshold switch (20) is acted upon by the voltage of the battery (2) and, on a drop below a set threshold value, charges a storage element (30), which actuates the control input of a trigger switch (50) through the switching path of which a continuous or intermittent current flows in the acoustic and/or optical indicating device (7) when the switch (3) is in the "off" position, and that in an intermediate position of the switch (3) the battery voltage is again applied to a second control input of the threshold switch (20) and the storage element (30) discharges if the set threshold value of the threshold switch (20) is again exceeded.

13. A circuit arrangement according to claim 12, characterised in that the switch (3) comprises a plurality of contact paths (31-37) which are so arranged that, in the "on" position, the second contact path (32) which is connected to the battery (2) is connected both to the first contact path (31), connected to the electrical load (1) and to the sixth contact path (36) connected to the first control input of the threshold switch (20), in the intermediate position of the switch (3) the second contact path (32) is connected both to the first contact path (31) and to the seventh contact path (37) connected to the second control input of the threshold switch (20), and in the "off" position of the switch (3) the second contact path (32) is connected to the fifth contact path (35) which is connected to the switch-path input of the trigger switch (50).

14. A circuit arrangement according to claim 12 or 13, characterised in that the threshold switch (20) comprises a voltage divider (23-27) which is connected on the one hand to the sixth contact path (36) and on the other hand to earth or reference potential, and to the first voltage-divider tap of which there is connected the base of a third transistor (21), a fifth diode which is connected at the anode side to the seventh contact path (37) and at the cathode side through a fourth resistor (22) to the collector of the third transistor (21) as well as a fifth resistor (29) which bridges tüe sixth contact path (36) and the fourth contact path (37), the emitter of the third transistor (21) being connected to earth or reference potential.

15. A circuit arrangement according to claim 12 or 13, characterised in that the storage element (30) consists of a second capacitor which is connected, on the one hand to the collector of the third transistor (21) and on the other hand to earth or reference potential.

16. A circuit arrangement according to claim 12 or 13, characterised in that the trigger switch (50) contains a fourth and fifth transistor (51, 52) in a complementary Darlington circuit, and the base of the fourth transistor (51) is connected through a sixth resistor (54) both to the collector of the third transistor (21) and through a third capacitor (53) to the collector of the fifth transistor (52), the collector of the fourth transistor (51) is connected to the base of the fifth transistor (52), the emitter of the fifth transistor (52) is connected to the fifth switch contact (35) of the switch (3) and the collector of the fifth transistor (52) is connected to the one terminal of the optical and/or acoustic indicating device (7), the other terminal of which is connected to earth or reference potential.

17. A circuit arrangement according to claim 16, characterised in that the collector of the fourth transistor (51) is connected through a fourth capacitor (61) to the fifth switch contact (35) of the switch (3).

18. A circuit arrangement according to claim 16 or 17, characterised in that the emitter of the fifth transistor (52) is connected to the cathode of a sixth diode (63), the anode of which is connected through a thirteenth resistor (62) to a second tap of the voltage divider (23-27).

19. A circuit arrangement according to one of the claims 16 to 18, characterised in that an eleventh resistor (59) is connected in parallel with the base-to-emitter path of the fifth transistor (52).

20. A circuit arrangement according to claim 14, characterised in that the voltage divider (23-27) comprises a first voltage-divider resistor (23) which is connected to the sixth contact path (36) of the switch (3) and the connection of which to a fifth voltage-divider resistor (24) forms the second voltage-divider tap, that the fifth voltage-divider resistor (24) is connected both to a sixth voltage-divider resistor (25) and to an NTC resistor (27) connected in parallel with the sixth voltage-divider resistor (25), the connection of the fifth voltage-divider resistor (24) to the sixth voltage-divider resistor (25) or to the NTC resistor (27) forming the first voltage-divider tap, and that a seventh voltage-divider resistor (26) is connected on the one hand to the parallel connection of the sixth voltage-divider resistor (25) and the NTC resistor (27) and on the other hand to earth or reference potential.

21. A circuit arrangement according to claim 14 or 20, characterised in that a fifth capacitor (40) is connected in parallel with the base-to-collector path of the third transistor (21).

22. A circuit arrangement according to one of the preceding claims 3 to 21, characterised in that the indicating device consists of a light-emitting diode (7), the anode of which is connected to the collector of the fifth transistor (52) and the cathode of which is connected to earth or reference potential.

23. A circuit arrangement according to one of the preceding claims 3 to 22, characterised in that the emitter of the fourth transistor (51) is connected to earth or reference potential through an eighth resistor (56).

**Revendications**

1. Procédé d'indication optique et/ou acoustique de l'état de charge ou de la réserve de charge d'une batterie ou d'un accumulateur pour l'alimentation en tension d'un consommateur électrique, par l'intermédiaire d'un commutateur de mode de fonctionnement, avec lequel à l'état de mise en circuit du consommateur électrique, l'état de charge est déterminé et mémorisé pendant la durée du fonctionnement du consommateur électrique et, après l'achèvement du fonctionnement, un dispositif d'indication optique et/ou acoustique est excité lors d'une chute en dessous d'un état limite de charge prédéterminé, caractérisé en ce que le commutateur de mode de fonctionnement (3) présente plusieurs positions de mise en circuit pour différents modes de fonctionnement du consommateur électrique (1), dans lesquelles un commutateur à valeur de seuil (4; 20) est commandé avec différentes valeurs de seuil pendant le mode de fonctionnement concerné du consommateur électrique (1), et en ce qu'un commutateur de déclenchement (6; 50) est commandé à partir du commutateur à valeur de seuil (4; 20) lorsque l'état de charge de la batterie (2) tombe, en fonction de la sollicitation intéressée, en dessous de l'état limite de charge déterminé.

2. Procédé suivant la revendication 1, caractérisé en ce que dans la position de mise en circuit du commutateur de mode de fonctionnement (3), l'électrode de commande d'un premier commutateur électronique (5) est raccordée à la batterie, le premier commutateur électronique (5) se bloquant alors avec une chute en dessous d'une tension de batterie pouvant être fixée et excitant un second commutateur électronique (6) qui est ensuite rendu conducteur, tandis que le premier commutateur électronique (5) reste bloqué, et en ce qu'avec le second commutateur électronique (6) conducteur, un premier condensateur (8) est rechargé d'un premier état de charge à un second présentant une polarité et tension de charge différente, et lors d'un déplacement du commutateur de mode de fonctionnement (3) à la position de coupure, le premier condensateur (8) est à nouveau rechargé à son premier état de charge, de telle sorte que pendant la recharge, le second commutateur électronique (6) est conducteur et, par l'intermédiaire de son intervalle de commande et du dispositif d'indication optique et/ou acoustique (7) connecté en série avec l'intervalle de commande, un courant circule.

3. Montage pour la mise en oeuvre du procédé suivant la revendication 1 ou 2, caractérisé en ce qu'en série avec les contacts de mise en circuit (32, 33) du commutateur de mode de fonctionnement (3) est connecté un diviseur de tension réglable (4), auquel est raccordée la base d'un premier transistor (5), dont le collecteur est relié, d'une part, par une résistance (10) directement ou par une résistance (10) et une résistance de diviseur de tension (41) aux contacts de mise en circuit (32, 33) du commutateur de mode de fonctionnement (3) et, d'autre part, à la base d'un second transistor (6) dont l'intervalle collecteur-émetteur est connecté en série avec le dispositif d'indication optique et/ou acoustique (7), au contact de coupure (31) du commutateur de mode de fonctionnement (3) et en parallèle avec son intervalle base-émetteur est connecté le montage série du condensateur (8) et d'une résistance de charge (9).

4. Montage suivant la revendication 3, caractérisé en ce que le commutateur de mode de fonctionnement (3) présente trois positions de commutation, dans la première desquelles le consommateur électrique (1) est mis hors circuit et une liaison existe entre la batterie (2) et le dispositif indicateur (7), dans la seconde desquelles le consommateur électrique (1) est en circuit dans un premier mode de fonctionnement et une liaison est établie avec une connexion du diviseur de tension (4), dont l'autre connexion est reliée à l'autre pôle de la batterie (2), et dans la troisième position desquelles le consommateur électrique (1) est mis en circuit dans un second mode de fonctionnement et une liaison est établie avec l'autre connexion du diviseur de tension (4).

5. Montage suivant la revendication 3 ou 4, caractérisé en ce que la base du premier transistor (5) est raccordée à un curseur d'un potentiomètre (45) du diviseur de tension (4), qui est connecté en série avec plusieurs résistances (41, 42, 43, 44).

6. Montage suivant une des revendications 3 - 5, caractérisé en ce qu'à l'une des connexions du potentiomètre (45), d'une part, et au potentiel de masse ou de référence ou à l'autre connexion de batterie, d'autre part, est raccordé le montage série de deux diodes (16, 17) avec une connexion côté anode au potentiomètre (45).

7. Montage suivant une des revendications 3 - 5, caractérisé en ce qu'à l'une des connexions du potentiomètre (45), d'une part, et au potentiel de masse ou de référence ou à l'autre connexion de batterie, d'autre part, est raccordée une résistance à coefficient de température négatif (18).

8. Montage suivant une des revendications 3 - 7, caractérisé en ce qu'en parallèle avec l'intervalle base-collecteur du premier transistor (5) est connecté un condensateur de filtrage (7).

9. Montage suivant une des revendications 3 - 8, caractérisé en ce que le collecteur du premier transistor (5) est relié à l'anode d'une diode (11), dont la cathode est raccordée à la base du second transistor (6).

10. Montage suivant une des revendications 3 - 9, caractérisé en ce qu'à la liaison des seconde et troisième résistances de diviseur de tension (42, 43), d'une part, et au collecteur du second transistor (6), d'autre part, est raccordé le montage série d'une première résistance (12) et d'une seconde diode (13), la diode (13) étant reliée côté cathode au collecteur du transistor (6).

11. Montage suivant une des revendications 3 - 10, caractérisé en ce qu'en parallèle avec l'intervalle base-émetteur du second transistor (6) est connectée une seconde résistance.

12. Montage pour la mise en oeuvre du procédé suivant la revendication 1, caractérisé en ce que dans la position de mise en circuit du commutateur de mode de fonctionnement (3), une première entrée de commande d'un commutateur à valeur de seuil (20) est sollicitée par la tension de la batterie (2) et lors d'une chute en dessous d'une valeur de seuil réglée, il charge un organe d'accumulation (30) qui excite l'entrée de commande d'un commutateur de déclenchement (50), par l'intermédiaire de l'intervalle de commande duquel, dans la position de coupure du commutateur (3), un courant continu ou intermittent circule dans le dispositif d'indication acoustique et/ou optique (7), et en ce qu'en une position intermédiaire du commutateur (3), une seconde entrée de commande du commutateur à valeur de seuil (20) est à nouveau sollicitée par la tension de batterie et il décharge l'organe d'accumulation (30) lorsqu'on dépasse à nouveau la valeur de seuil réglée du commutateur à valeur de seuil (20).

13. Montage suivant la revendication 12, caractérisé en ce que le commutateur (3) présente plusieurs pistes de contact (31-37) qui sont agencées de telle sorte que dans la position de mise en circuit, la seconde piste de contact (32) reliée à la batterie (2) est reliée à la première piste de contact (31) reliée au consommateur électrique (1) aussi bien qu'à la sixième piste de contact (36) reliée à la première entrée de commande du commutateur à valeur de seuil (20), dans la position intermédiaire du commutateur (3) la seconde piste de contact (32) est reliée à la première piste de contact (31) aussi bien qu'à la septième piste de contact (37) reliée à la seconde entrée de commande du commutateur à valeur de seuil (20), et dans la position de coupure du commutateur (3) la seconde piste de contact (32) est reliée à la cinquième piste de contact (35) raccordée à l'entrée de l'intervalle de commande du commutateur de déclenchement (50).

14. Montage suivant la revendication 12 ou 13, caractérisé en ce que le commutateur à valeur de seuil (20) présente un diviseur de tension (23-27) qui est relié, d'une part, à la sixième piste de contact (36) et, d'autre part, au potentiel de masse ou de référence, et à la première prise de diviseur de tension duquel est raccordée la base d'un troisième transistor (21), une cinquième diode reliée côté anode à la septième piste de contact (37) et côté cathode par une quatrième résistance (22) au collecteur du troisième transistor (21), ainsi qu'une cinquième résistance (29) shuntant la sixième piste de contact (36) et la quatrième piste de contact (37), l'émetteur du troisième transistor (21) étant relié au potentiel de masse ou de référence.

15. Montage suivant la revendication 12 ou 13, caractérisé en ce que l'organe d'accumulation (30) est constitué par un second condensateur qui est raccordé, d'une part, au collecteur du troisième transistor (21) et, d'autre part, au potentiel de masse ou de référence.

16. Montage suivant la revendication 12 ou 13, caractérisé en ce que le commutateur de déclenchement (50) comporte un quatrième et un cinquième transistor (51, 52) en montage Darlington complémentaire, la base du quatrième transistor (51) étant reliée par une sixième résistance (54) au collecteur du troisième transistor (21) aussi bien que par un troisième condensateur (53) au collecteur du cinquième transistor (52), le collecteur du quatrième transistor (51) à la base du cinquième transistor (52), l'émetteur du cinquième transistor (52) au cinquième contact de commutation (35) du commutateur (3), et le collecteur du cinquième transistor (52) à l'une des connexions du dispositif d'indication optique et/ou acoustique (7), dont l'autre connexion est raccordée au potentiel de masse ou de référence.

17. Montage suivant la revendication 16, caractérisé en ce que le collecteur du quatrième transistor (51) est relié par un quatrième condensateur (61) au cinquième contact de commutation (35) du commutateur (3).

18. Montage suivant la revendication 16 ou 17, caractérisé en ce que l'émetteur du cinquième transistor (52) est raccordé à la cathode d'une sixième diode (63), dont l'anode est reliée par une treizième résistance (62) à une seconde prise du diviseur de tension (23-27).

19. Montage suivant une des revendications 16 à 18, caractérisé en ce qu'en parallèle avec l'intervalle base-émetteur du cinquième transistor (52) est connectée une onzième résistance (59).

20. Montage suivant la revendication 14, caractérisé en ce que le diviseur de tension (23-27) présente une première résistance de diviseur de tension (23) reliée à la sixième piste de contact (36) du commutateur (3), dont la jonction avec une cinquième résistance de diviseur de tension (24) forme la seconde prise de diviseur de tension, en ce que la cinquième résistance de diviseur de tension (24) est reliée à une sixième résistance de diviseur de tension (25) aussi bien qu'à une résistance à coefficient de température négatif (27) connectée en parallèle avec la sixième résistance de diviseur de tension (25), la jonction de la cinquième résistance de diviseur de tension (24) avec la sixième résistance de diviseur de tension (25) ou la résistance à coefficient de température négatif (27) formant la première prise de diviseur de tension, et en ce qu'une septième résistance de diviseur de tension (26) est raccordée au montage parallèle de la sixième résistance de diviseur de tension (25) avec la résistance à coefficient de température négatif (27), d'une part, et au potentiel de masse ou de référence, d'autre part.

21. Montage suivant la revendication 14 ou 20, caractérisé en ce qu'en parallèle avec l'intervalle base-collecteur du troisième transistor (21) est connecté un cinquième condensateur (40).

22. Montage suivant une des revendications précédentes 3 à 21, caractérisé en ce que le dispositif indicateur est constitué par une diode électroluminescente (7), dont l'anode est reliée au collecteur du cinquième transistor (52) et dont la cathode est reliée au potentiel de masse ou de référence.

23. Montage suivant une des revendications précédentes 3 à 22, caractérisé en ce que l'émetteur du quatrième transistor (51) est relié par une huitième résistance (56) au potentiel de masse ou de référence.

# FIG.1

# FIG.2

# FIG. 3